# EUROPEAN PATENT APPLICATION

(11) **EP 1 675 173 A2**
(43) Date of publication of application: **28.06.2006**
(21) Application number: 05077640.0
(22) Date of filing: 22.11.2005
(51) Int. Cl.: H01L 23/367

(54) **Epoxy-solder thermally conductive structure for an integrated circuit**

(30) Priority: 06.12.2004 US 5277
(71) Applicant: Delphi Technologies, Inc., Troy, MI 48007 (US)
(72) Inventor: Brandenburg, Scott D., Kokomo, IN 46902 (US)
(74) Representative: Denton, Michael John

(57) **Abstract**

A technique for providing a thermally conductive structure for an integrated circuit (IC) chip utilizes a solder and an epoxy. The solder is positioned on at least one of a first side of a heat sink or on a non-active side of the chip. The non-active side of the chip is then positioned adjacent the first side of the heat sink. The epoxy is then positioned around a perimeter of the chip. The epoxy is cured and the solder is reflowed to thermally couple and attach the non-active side of the IC chip to the heat sink.

## Description

### TECHNICAL FIELD

The present invention is generally directed to thermal management of integrated circuits and, more specifically, to an epoxy-solder thermally conductive structure for an integrated circuit.

### BACKGROUND OF THE INVENTION

The evolution of integrated circuits (ICs) has resulted in electronic devices that have decreased in size and increased in speed, power dissipation and density. As power dissipation of electronic devices has increased, so has the need for better thermal management techniques. For example, current thermal management techniques for flip chip packaged electronic devices are generally only capable of providing a power density of 40 W/cm². However, future flip chip packaged devices may require power densities of 125 W/cm², or greater. Thus, without better thermal management solutions, chip size may have to be increased or the performance (i.e., speed) of the chip may need to be decreased, which, in general, provides a less desirable end-product.

Traditionally, thermal management has been achieved by utilizing metal heat sinks that are in thermal contact with a non-active side of a an IC chip, e.g., a flip chip or other electronic device package, and have utilized dispensed thermally conductive grease or an adhesive positioned between the non-active side of the flip chip and the heat sink to increase the thermal conductivity between the flip chip and the heat sink. Unfortunately, using thermal grease to increase heat transfer between the flip chip and the heat sink can be a messy proposition. Further, thermal grease typically only provides a modest increase in heat transfer as the thermal conductivity of the grease is relatively poor, generally in the range of 0.7 W/mK, as compared to a heat sink, which may have a thermal conductivity over 200 W/mK.

In assemblies implementing the above configurations, a silicon elastomer has usually been positioned within the assembly to force the flip chip in contact with the heat sink. Other assemblies have utilized different thermally conductive materials between the heat sink and a non-active surface of the flip chip, such as thermal films or pads. In general, these thermal materials have usually been applied through hand placement or using automated pick-and-place techniques. Typically, such thermal films or pads improve thermal conductivity between the flip chip and the heat sink. For example, some thermally conductive film or pads may have a thermal conductivity of up to 7.5 W/mK. However, in general, the utilization of greases and thermally conductive films and pads provide a heat transfer on the order of one to two magnitudes below the thermal conductivity of the heat sink.

Other assemblies have utilized solder as the thermal compound between a non-active side of an IC chip and a metal heat sink, due to the low interfacial resistance and excellent bulk thermal properties of typical solders. However, the fatigue life of a solder thermal joint is somewhat limited due to stresses induced by coefficient of thermal expansion (CTE) mismatch between silicon and the heat sink (typically made of copper). Still other assemblies have utilized polymer solders, which are a mixture of polymer material and solder spheres, as the thermal compound between an IC chip and a heat sink. Unfortunately, while polymer solders have longer working lives, polymer solders exhibit lower thermal performance than solder alone. This is due to the discontinuity in the thermal path, as the solder spheres are separated by the polymer material.

What is needed is a thermally conductive structure that provides for adequate thermal conductivity between a non-active side of an IC chip and an associated heat sink, while providing a satisfactory working life.

### SUMMARY OF THE INVENTION

An embodiment of the present invention is directed a technique for providing a thermally conductive structure for an integrated circuit (IC) chip that utilizes a solder and an epoxy. Initially, the solder is positioned on at least one of a first side of a heat sink or on a non-active side of the chip. The non-active side of the chip is then positioned adjacent the first side of the heat sink. The epoxy is then positioned around a perimeter of the IC chip. The epoxy is cured and the solder is reflowed to thermally couple and attach the non-active side of the IC chip to the heat sink. The solder covers approximately eighty to ninety-five percent of a surface area of the chip and the epoxy covers approximately five to twenty percent of the surface area of the chip.

According to another aspect of the present invention, the solder is an indium solder. According to a different aspect, a coefficient of thermal expansion (CTE) of the solder is about 29 ppm/°C and a CTE of the epoxy is about 38 ppm/°C. According to yet another embodiment, the solder is reflowed at about 170 degrees Celsius for about twenty minutes. According to a different aspect, the epoxy is cured at about 150 degrees Celsius for about twenty minutes. According to yet another aspect, the thermal conductivity of the solder is about 86 W/mK and the thermal conductivity of the epoxy is about 0.7 W/mK. According to a different embodiment, the shear strength of the solder is about 890 PSI and the shear strength of the epoxy is about 9000 PSI.

These and other features, advantages and objects of the present invention will be further understood and appreciated by those skilled in the art by reference to the following specification, claims and appended drawings.

### BRIEF DESCRIPTION OF THE DRAWINGS

The present invention will now be described, by way of example, with reference to the accompanying drawings, in which:
Figs. 1 is a cross-sectional view of an exemplary electronic assembly, constructed according to one embodiment of the present invention; and
Fig. 2 is an exemplary process for manufacturing the electronic assembly of Fig. 1.

### DESCRIPTION OF THE PREFERRED EMBODIMENTS

As is discussed above, polymer solders provide questionable long-term performance and reliability and exhibit compromised thermal performance as, in general, the solder spheres are separated by the polymer material and a discontinuity in thermal path exists. As is also discussed above, electronic assemblies utilizing standard solders as a thermal interface, between a non-active side of an integrated circuit (IC) chip and a heat sink, may also exhibit reduced thermal performance. This reduced thermal performance is generally attributable to solder cracks caused by temperature cycling and high-shear stress due to coefficient of thermal expansion (CTE) mismatches between the material of the die, e.g., silicon, and the material of the heat sink, e.g., copper.

According to the present invention, a technique is disclosed, which provides a longer working life than solder alone, while exhibiting greater thermal conductivity than polymer solders. According to the present invention, a thermally conductive structure is disclosed that utilizes solder to provide a thermal interconnection between a back-side of a center section of an IC chip and a metal sink. The structure utilizes an epoxy adhesive around the perimeter of the chip to provide a structural bond between the chip and the heat sink. In general, the solder may be an indium solder and the epoxy may be a standard epoxy that has the characteristics discussed below. For example, an epoxy that provides about a 9000 PSI shear strength, a thermal conductivity of approximately 0.7 W/mK and a CTE of about 38 ppm/°C, when cured at about 150 degrees Celsius for about twenty minutes, provides an adequate epoxy. An indium solder having a shear strength of about 890 PSI, a thermal conductivity of approximately 86 W/mK and a CTE of about 29 ppm/°C, when cured at about 170 degrees for about twenty minutes, provides an adequate thermal structure.

The solder may be pre-soldered on the heat sink. Alternatively, the solder may be positioned on at least one of the heat sink and a non-active side of the IC chip. Following positioning of the solder, the epoxy is dispensed around the perimeter of the chip. The chip is then placed on the heat sink, the epoxy is cured, and the solder is reflowed. Based upon the selected materials, an appropriate solder reflow temperature and epoxy cure time can be selected so that both reflow and cure occur during the same time period.

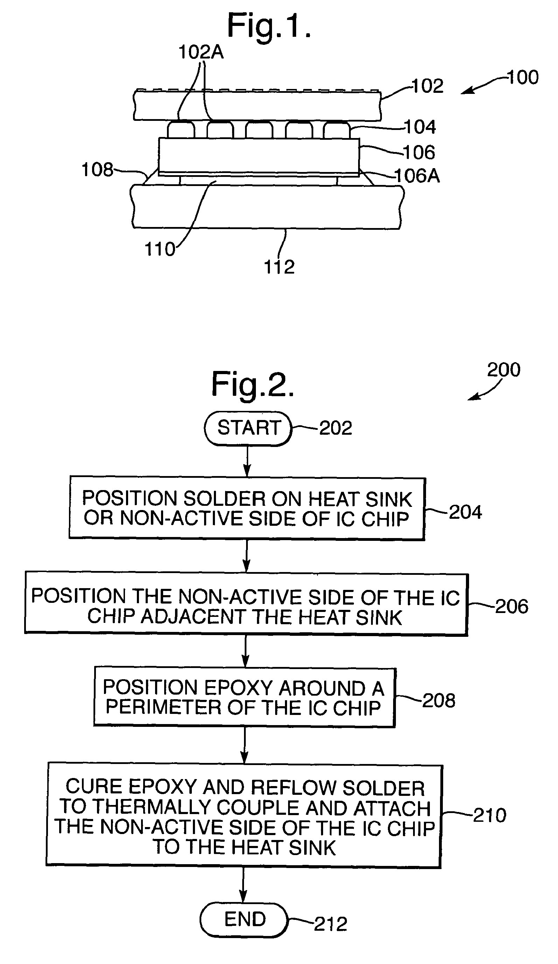

With reference to Fig. 1, a portion of an exemplary electronic assembly 100 is depicted. The assembly 100 includes a substrate 102 having a plurality of conductive traces 102A, which are electrically coupled to an integrated circuit (IC), e.g., a flip chip 106, via solder bumps 104. A non-active side of the chip 106 includes a conductive metal. The conductive metal is bonded with a solder 110, e.g., an indium solder, that is located between the non-active side of the chip 106, to a heat sink 112. As is also shown in Fig. 1, an epoxy 108 is deposited around the perimeter of the chip 106. The solder 110 is located to cover a surface area of approximately eighty to ninety-five percent of the chip 106 and the structural epoxy adhesive is positioned around the perimeter of the chip 106 to cover approximately five to twenty percent of the surface area of the chip 106.

It should be appreciated that when the epoxy and solder are utilized together, they create a thermal joint that has a high thermal conductivity and a longer fatigue life, as the structural epoxy is located at the edges of the devices, where larger stresses occur. A test sample including a 0.25 inch square silicon IC chip mounted on a copper slug (with a thermally conductive structure configured according to the present invention) exhibited no solder cracking after being thermally cycled, between -40 degrees Celsius to +150 degrees Celsius, for 1000 hours. In the test sample, an indium solder preform and a Cookson 3090 snap cure epoxy adhesive were utilized. In the test sample, the materials were subjected to 170 degrees Celsius for two minutes to facilitate reflow of the solder and cure of the epoxy. It should be appreciated that the epoxy could be utilized with various other solders, such as a 10/90 Sn/Pb solder, and that a production material may broadly consist of a solder and a B-stage epoxy preform.

Accordingly, a thermally conductive structure for an integrated circuit (IC) has been described herein that provides a thermal joint with high thermal conductivity and longer fatigue life than current solutions. Such an epoxy-solder structure is particularly advantageous when implemented in an electronic assembly utilized in an automotive environment, as the assemblies are increasingly subjected to higher temperatures and wider temperature ranges. The thermally conductive structure provides for increased thermal conductivity for integrated circuit (IC) chips of electronic modules. The thermally conductive structure is particularly advantageous when implemented in automotive electronic modules, where higher power densities are increasingly required.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method for providing a thermally conductive structure for an integrated circuit (IC) chip, comprising the steps of:
centrally positioning a solder on at least one of a first side of a heat sink or on a non-active side of an IC chip;
positioning the non-active side of the chip adjacent the first side of the heat sink;
positioning an epoxy around a perimeter of the chip;
curing the epoxy and reflowing the solder to thermally couple and attach the non-active side of the chip to the heat sink, wherein the solder covers approximately eighty to ninety-five percent of a surface area of the chip and the epoxy covers approximately five to twenty percent of the surface area of the chip.

2. The method of claim 1, wherein the solder is an indium solder.

3. The method of claim 1, wherein the coefficient of thermal expansion (CTE) of the solder is about 29 ppm/°C.

4. The method of claim 3, wherein the coefficient of thermal expansion (CTE) of the epoxy is about 38 ppm/°C.

5. The method of claim 1, wherein the solder is reflowed at about 170 degrees Celsius for about twenty minutes.

6. The method of claim 5, wherein the epoxy is cured at about 150 degrees Celsius for about twenty minutes.

7. The method of claim 1, wherein the thermal conductivity of the solder is about 86 W/mK.

8. The method of claim 7, wherein the thermal conductivity of the epoxy is about 0.7 W/mK.

9. The method of claim 1, wherein the shear strength of the solder is about 890 PSI.

10. The method of claim 9, wherein the shear strength of the epoxy is about 9000 PSI.

11. A method for providing a thermally conductive structure for an integrated circuit (IC) chip, comprising the steps of:
centrally positioning a solder on a first side of a heat sink;
positioning a non-active side of an IC chip in contact with the solder on the first side of the heat sink;
positioning an epoxy around a perimeter of the IC chip;
curing the epoxy and reflowing the solder to thermally couple and attach the non-active side of the IC chip to the heat sink, wherein the solder covers approximately eighty to ninety-five percent of a surface area of the chip and the epoxy covers approximately five to twenty percent of the surface area of the chip.

12. The method of claim 11, wherein the solder is an indium solder.

13. The method of claim 11, wherein the coefficient of thermal expansion (CTE) of the solder is about 29 ppm/°C.

14. The method of claim 11, wherein the coefficient of thermal expansion (CTE) of the epoxy is about 38 ppm/°C.

15. The method of claim 11, wherein the solder is reflowed at about 170 degrees Celsius for about twenty minutes.

16. The method of claim 11, wherein the epoxy is cured at about 150 degrees Celsius for about twenty minutes.

17. The method of claim 11, wherein the thermal conductivity of the solder is about 86 W/mK.

18. The method of claim 11, wherein the thermal conductivity of the epoxy is about 0.7 W/mK.

19. The method of claim 11, wherein the shear strength of the solder is about 890 PSI.

20. The method of claim 19, wherein the shear strength of the epoxy is about 9000 PSI.

21. An electronic module, comprising:
a substrate;
a heat sink;
an integrated circuit (IC) chip electrically coupled to conductive traces of the substrate on an active side of the chip, wherein the chip includes a thermally conductive structure located between the heat sink and a non-active side of the chip, and wherein the thermally conductive structure is bonded between the chip and the heat sink through the following steps:
centrally positioning a solder on at least one of a first side of the heat sink or on the non-active side of the chip;
positioning the non-active side of the chip adjacent the first side of the heat sink;
positioning an epoxy around a perimeter of the chip; and
curing the epoxy and reflowing the solder to thermally couple and attach the non-active side of the chip to the heat sink, wherein the solder covers approximately eighty to ninety-five percent of a surface area of the chip and the epoxy covers approximately five to twenty percent of the surface area of the chip.
